# EUROPEAN PATENT APPLICATION

(11) **EP 2 403 001 A2**
(43) Date of publication of application: **04.01.2012**
(21) Application number: 11171376.4
(22) Date of filing: 24.06.2011
(51) Int. Cl.: H01L 31/0224, H01L 31/18

(54) **Photovoltaic cell and methods for forming a back contact for a photovoltaic cell**

(30) Priority: 29.06.2010 US 826234
(71) Applicant: General Electric Company, Schenectady, NY 12345 (US)
(72) Inventor: Korevaar, Bastiaan Arie, Niskayuna, NY New York 12309 (US); Rojo, Juan Carlos, Niskayuna, NY New York 12309 (US); Ahmad, Faisal Razi, Niskayuna, NY New York 12309 (US); Vernooy, David William, Niskayuna, NY New York 12309 (US)
(74) Representative: Szary, Anne Catherine

(57) **Abstract**

Methods are provided for forming a back contact (12) for a photovoltaic cell (10) that includes at least one semiconductor layer (22, 24). One method includes depositing at least one back contact material (16) on a metal contact (20). The back contact material comprises a metal nitride or a metal phosphide. The method further includes depositing an absorber layer (22) comprising cadmium and tellurium above the back contact material and thermally processing the back contact material, such that the back contact material interacts with the absorber layer to form an interlayer (30) that lowers a contact resistance for the photovoltaic cell. A photovoltaic cell (10) is also provided and includes comprising a metal contact, at least one back contact material disposed on the metal contact, and an absorber layer comprising a material comprising cadmium and tellurium disposed above the back contact material. An interlayer is disposed between the back contact material and the absorber layer and comprises a compositionally graded layer (30) of the back contact material and the absorber layer material. The photovoltaic cell further includes a window layer disposed above the absorber layer.

## Description

### BACKGROUND

The invention relates generally to photovoltaic cells and, more particularly, to methods for forming back contact electrodes for photovoltaic cells.

Solar energy is abundant in many parts of the world year round. Thus, photovoltaic (PV) devices, which convert solar energy into electrical energy, have the potential to provide a reliable form of clean renewable energy in many parts of the world. Typically, in its basic form, a PV (or solar) cell includes a semiconductor junction made of two or three layers that are disposed on a substrate layer, and two contacts (electrically conductive layers) for passing electrical energy in the form of electrical current to an external circuit. Moreover, additional layers are often employed to enhance the conversion efficiency of the PV device.

There are a variety of candidate material systems for PV cells, each of which has certain advantages and disadvantages. Cadmium telluride (CdTe) is a prominent polycrystalline thin-film material, with a nearly ideal bandgap of about 1.45-1.5 electron volts. CdTe also has a very high absorptivity, and films of CdTe can be manufactured using low-cost techniques. In theory, solar cell efficiencies in excess of twenty percent (20%) could be achieved for cadmium sulfide (CdS)/CdTe devices, provided various issues with the quality of the individual semiconductor layers and with the back contact electrode can be overcome.

Because of the high work function of CdTe, conventional metal back contacts are not generally viewed as being suitable. Instead, graphite pastes (either undoped or doped, for example with copper or mercury) are widely used as a back contact for CdTe PV cells. However, these graphite-paste back contacts tend to degrade significantly over time, as can be shown via accelerated lifetime testing. This degradation typically manifests itself as a decrease in fill factor (FF) and/or open circuit voltage V_{oc} over time. The fill factor degradation is typically driven by a decrease in shunt resistance (*R*ₛₕ) and an increase in the series resistance (R_{oc}) over time. The degradation of the back contact electrodes undesirably leads to degradation of the solar cell efficiency, on a long-term basis.

To date, the failure to develop low-resistance contacts has hindered the commercialization of CdTe solar cells. A cost-effective solution to this problem would remove one of the remaining hurdles for commercializing CdTe photovoltaic modules.

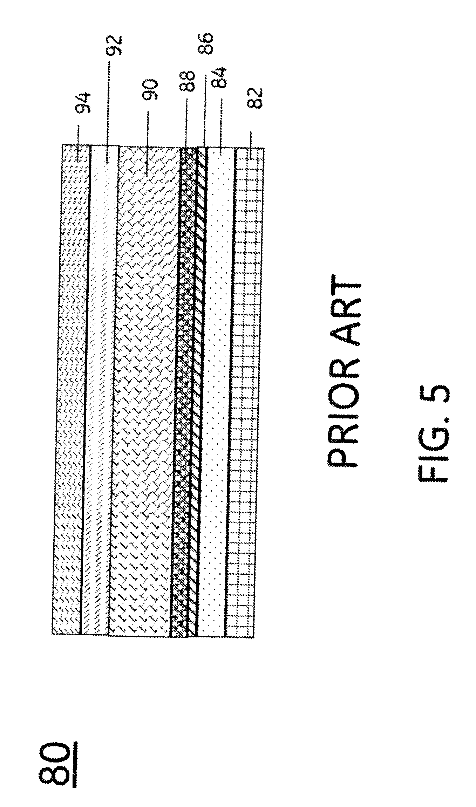

Another technical challenge for manufacturing CdTe solar cells is optimizing the properties of the window layers, as CdTe PV devices are conventionally grown in a "superstrate" configuration, as illustrated in FIG. 5. As shown in FIG. 5, the CdTe solar cell 80 is formed on a glass substrate 82. A transparent conductive layer 84, typically a TCO layer 84 is deposited on the glass substrate 82. Next, an optional high resistance transparent conductive oxide (HRT) layer 86 may be deposited on the TCO layer 84, and typically a CdS layer 88 is deposited on the HRT layer 86. A CdTe layer 90 is deposited on the CdS layer 88, and a back contact 92 is formed. In addition, an upper glass substrate 94 may be included to provide an inexpensive, environmental barrier. Thus, for conventional CdTe cells manufactured in superstrate geometries, it may not be possible to optimize the window layer because of the subsequent deposition of the absorber layer at high temperatures and consecutive high temperature treatments of the device.

It would therefore be desirable to provide a back-contact for CdTe solar cells with lower contact resistance. It would further be desirable to provide a method of manufacture for CdTe solar cells, which facilitates optimizing the properties of the window layer.

### BRIEF DESCRIPTION

One aspect of the present invention resides in a method for forming a back contact for a photovoltaic cell that includes at least one semiconductor layer. The method includes depositing at least one back contact material on a metal contact. The back contact material comprises a metal nitride or a metal phosphide. The method further includes depositing an absorber layer comprising cadmium and tellurium above the back contact material and thermally processing the back contact material, such that the back contact material interacts with the absorber layer to form an interlayer that lowers a contact resistance for the photovoltaic cell. The method further includes depositing a window layer above the absorber layer.

Another aspect of the present invention resides in a method for forming a back contact for a photovoltaic cell that includes at least one semiconductor layer. The method includes depositing at least one back contact material on a metal contact. The back contact material comprises magnesium, zinc, copper, mercury, manganese, cesium, arsenic, antimony, bismuth or combinations thereof. The method further includes depositing an absorber layer comprising cadmium (Cd) and tellurium (Te) above the back contact material and depositing a window layer above the absorber layer.

Yet another aspect of the present invention resides in a photovoltaic cell comprising a metal contact. At least one back contact material is disposed on the metal contact. The photovoltaic cell further includes an absorber layer comprising a material comprising cadmium and tellurium disposed above the back contact material. An interlayer is disposed between the back contact material and the absorber layer. The interlayer comprises a compositionally graded layer of the back contact material and the absorber layer material. The photovoltaic cell further includes a window layer disposed above the absorber layer.

Another aspect of the present invention resides in a method for forming a back contact for a photovoltaic cell that includes at least one semiconductor layer. The method includes depositing at least one back contact material on a metal contact. The back contact material comprises indium, gallium, aluminum or combinations thereof. The method further includes depositing an absorber layer comprising cadmium (Cd) and tellurium (Te) above the back contact material and depositing a window layer above the absorber layer.

### DRAWINGS

These and other features, aspects, and advantages of the present invention will become better understood when the following detailed description is read with reference to the accompanying drawings in which like characters represent like parts throughout the drawings, wherein:
FIG. 1 is a schematic cross-sectional diagram of an example photovoltaic cell, in accordance with various embodiments of the present invention;
FIG. 2 is a schematic cross-sectional diagram of an example photovoltaic cell with a buried junction, in accordance with various embodiments of the present invention;
**FIG. 3** is a schematic cross-sectional diagram of an example photovoltaic cell with a p+ zone, in accordance with various embodiments of the present invention;
**FIG. 4** is a schematic cross-sectional diagram of an example photovoltaic cell with telluride formed at the interface between the back contact material and the absorber layer, in accordance with various embodiments of the present invention;
**FIG. 5** illustrates a conventional CdTe PV cell manufactured in a "superstrate" configuration;
**FIG. 6** illustrates a method of forming a back contact for a photovoltaic cell, in accordance with various embodiments of the present invention;
**FIG. 7** illustrates a method of forming a back contact for a photovoltaic cell with a buried junction, in accordance with various embodiments of the present invention;
**FIG. 8** illustrates another method of forming a back contact for a photovoltaic cell, in accordance with various embodiments of the present invention; and
**FIG. 9** illustrates another method of forming a back contact for a photovoltaic cell with a buried junction, in accordance with various embodiments of the present invention.

### DETAILED DESCRIPTION

As noted above, the high work function of CdTe leaves a relatively small set of metals that can be employed to form an Ohmic contact with the CdTe layer. Suitable metals include platinum and gold, which are not commercially viable candidates for low-cost CdTe PV cells. However, lower cost metals, such as molybdenum, nickel, and chromium, typically form a tunneling barrier at the interface between the back contact and the CdTe layer. As CdTe typically has carrier densities between about 1 x 10¹⁴ to about 1 x 10¹⁵ per cubic centimeter, this tunneling barrier may be relatively large. Thus, absent proper treatment of the backside of the CdTe layer, the resistance with the back contact layer can be significant, thereby reducing the fill factor (and hence the efficiency) of the PV cell.

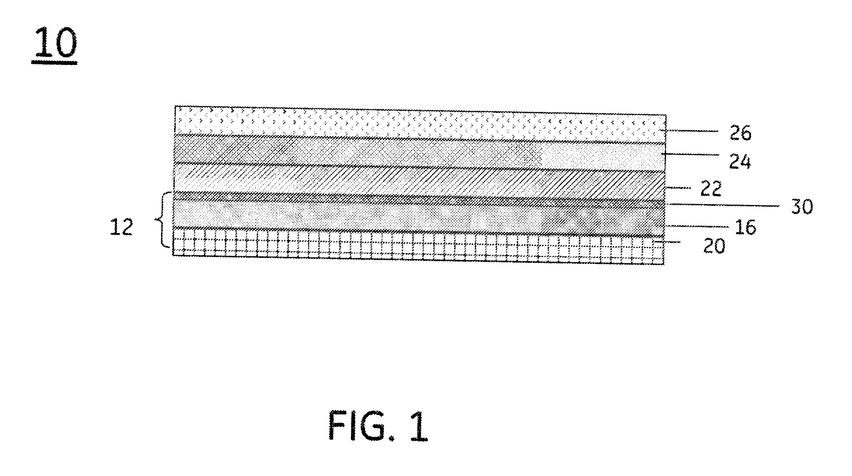

Moreover, forming low resistance back-contacts for CdTe PV cells fabricated in a "substrate" configuration (as opposed to the "superstrate" configuration described above with reference to FIG. 5) has proved to be extremely difficult. The present invention addresses these issues, and methods for forming an improved back contact 12 for a photovoltaic cell 10 grown in a "substrate" configuration is provided. The methods are described with reference to FIGS. 1-4, 6 and 7. For the illustrated arrangements, the PV cell 10 is formed in a "substrate" configuration, in contrast with the cell 80 described above with reference to FIG. 5 that is formed in a conventional "superstrate" configuration.

As indicated, for example, in FIG. 1, the photovoltaic cell 10 includes at least one semiconductor layer 22. For the illustrated arrangements, the semiconductor layer 22 comprises cadmium telluride (CdTe). Although the examples provided are directed to CdTe, the invention can be used to form improved back contact electrodes for other semiconductors as well. Other example materials for semiconductor layer 22 include, without limitation, CdZnₓTe₁₋ₓ and CdSₓTe₁₋ₓ, with x being less than 0.1.

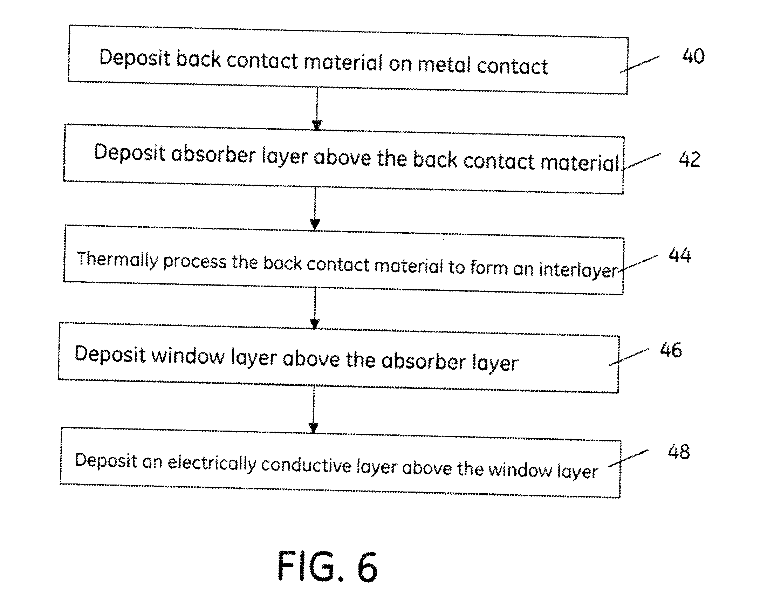

As indicated, for example, in FIGS. 1 and 6, a method for forming a back contact 12 for a photovoltaic cell 10 includes, at step 40, depositing at least one back contact material 16 on a metal contact 20. The back contact material comprises a metal nitride or a metal phosphide. For particular embodiments, the back contact material 16 comprises a metal nitride. Non-limiting examples of suitable metal nitrides include tantalum nitride, molybdenum nitride and tungsten nitride. For particular configurations, a 1-200 nanometer (nm) thick layer, and more particularly, a 50-100 nm thick layer of metal nitride is deposited on the metal contact 20. The metal nitride may be deposited, for example, by reactive sputtering.

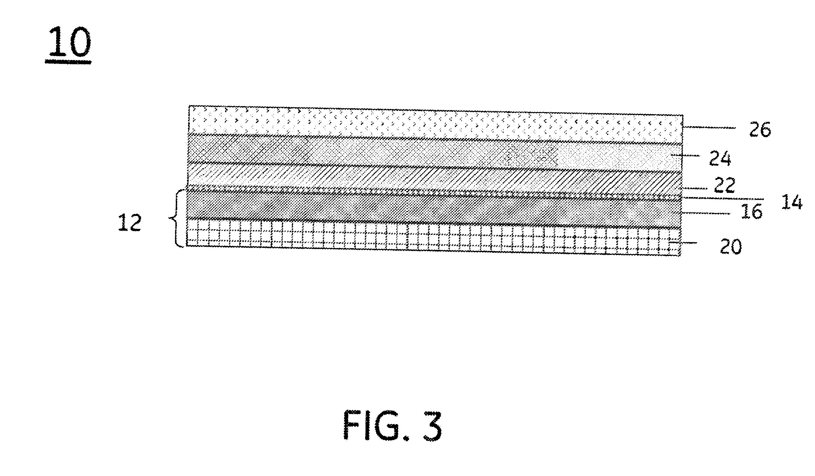

For other embodiments, the back contact material 16 comprises a metal phosphide. Non-limiting examples of suitable metal phosphides include nickel phosphide (NiP). For particular configurations, a 1-200 nm, and more particularly, 50-100 nm thick layer of metal phosphide is deposited on the metal contact 20. The metal phosphide may be deposited, for example, by electroplating. For this embodiment, phosphor diffuses out of the metal phosphide, forming a p+ zone 14, as indicated for example in FIG. 3.

Referring again to FIGS. 1 and 6, the method further includes, at step 42 depositing an absorber layer 22 comprising cadmium (Cd) and tellurium (Te) above the back contact material 16. According to particular embodiments, the absorber layer 22 comprises a material selected from the group consisting of cadmium telluride, cadmium zinc telluride, cadmium sulfur telluride, cadmium manganese telluride, cadmium magnesium telluride and combinations thereof. More generally, the absorber layer 22 may, in certain embodiments, comprise other elements from the Group II and Group VI or Group III and Group V that will not result in large bandgap shifts (for example, bandgap shifts that are < 0.1 eV), such as zinc, sulfur, manganese and magnesium. For specific configurations, the atomic percent of cadmium in the CdTe is in the range from about 48-52 atomic percent, and the atomic percent of tellurium in the CdTe is in the range from about 45-55 atomic percent. The CdTe employed may be Te-rich, for example the atomic percent of tellurium may be in the range from about 52-55 atomic percent. For specific configurations, the atomic percent of zinc, sulfur, manganese, or magnesium in the CdTe is less than about 10 atomic percent, and more particularly, about 8 atomic percent, and still more particularly, about 6 atomic percent, with the bandgap staying in the 1.4-1.6 eV range. It has been postulated that by adding a small atomic percent of zinc, the defect density of the resulting intrinsic cadmium zinc telluride is reduced relative to CdTe. However, it is possible that instead the defect state may shift to a different energy level within the band, resulting in a different self-compensating level, e.g., may result in more donor/acceptor type states, or a less deep defect, that may improve the lifetime. However, ten atomic percent of zinc will bring the bandgap up to about 1.55 eV. Similarly, the addition of sulfur will vary the bandgap of the resulting intrinsic cadmium sulfur telluride between about 1.4 and 1.5 eV, for small atomic S percentages. See, for example, D.W. Lane, "A review of the optical band gap of thin film CdSxTe1-x," Solar Energy Materials & Solar Cells 90 (2006) 1169―1175, and Jihua Yang et al., "Alloy composition and electronic structure of Cd1-xZnxTe by surface photovoltage spectroscopy," Journal of Applied Physics, Vol. 91, No. 2, p. 703-707.

As indicated in FIGS. 1 and 6, the method further includes, at step 44, thermally processing the back contact material 16, such that the back contact material interacts with the absorber layer 22 to form an interlayer 30 that lowers a contact resistance for the photovoltaic cell 10. For particular embodiments, the thermal processing comprises performing a thermal treatment on the absorber layer 22 after the deposition of the absorber layer 22, where the deposition and thermal treatment of the absorber layer 22 complete the formation of the back contact 12 for the photovoltaic cell 10. According to more particular embodiments, the thermal treatment comprises annealing the absorber layer 22. For example, the absorber layer 22 may be annealed at a temperature in a range of about 400-600 degrees Celsius for a period of about 5-30 minutes.

For other embodiments, the thermal processing is achieved by means of the deposition of the absorber layer 22, which completes the formation of the back contact 12 for the photovoltaic cell 10.

Referring again to FIGS. 1 and 6, the method further includes, at step 46 depositing a window layer 24 above the absorber layer 22. The window layer 24 is the junction-forming layer for the PV device 10, for the configuration shown in FIG. 1. The addition of the window layer 24 induces an electric field that produces the photovoltaic effect. For particular embodiments, the window layer 24 comprises a material selected from the group consisting of cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂O) amorphous or micro-crystalline silicon and Zn(O,H) and combinations thereof. In one non-limiting example, the window layer 24 comprises CdS and has a thickness in a range of about 50-200 nm, and more particularly between 50 and 100 nm. The atomic percent of cadmium in the cadmium sulfide, for certain configurations, is in a range of about 45-55 atomic percent, and more particularly, in a range of about 48-52 atomic percent.

In addition, for the arrangement shown in FIG. 1, the method further includes, at step 48, depositing an electrically conductive layer 26 above the window layer 24. For certain arrangements, the electrically conductive layer 26 comprises a transparent conductive oxide (TCO). Non-limiting examples of transparent conductive oxides include indium tin oxide (ITO), fluorine-doped tin oxide (SnO:F) or FTO, indium-doped cadmium-oxide, cadmium stannate (Cd₂Sn0₄) or CTO, and doped zinc oxide (ZnO), such as aluminum-doped zinc-oxide (ZnO:Al) or AZO, indium-zinc oxide (IZO), and zinc tin oxide (ZnSnOₓ), and combinations thereof. Depending on the specific TCO employed (and on its sheet resistance), the thickness of the TCO layer 22 may be in the range of about 50-600 nm and, more particularly, 100-200 nm.

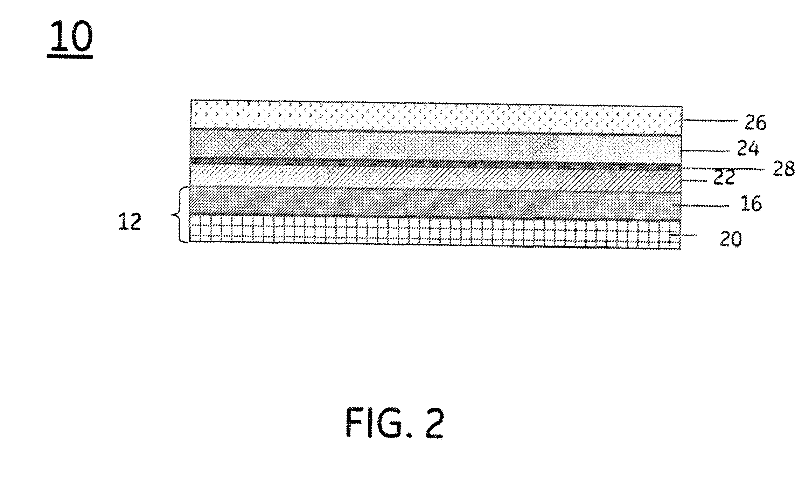

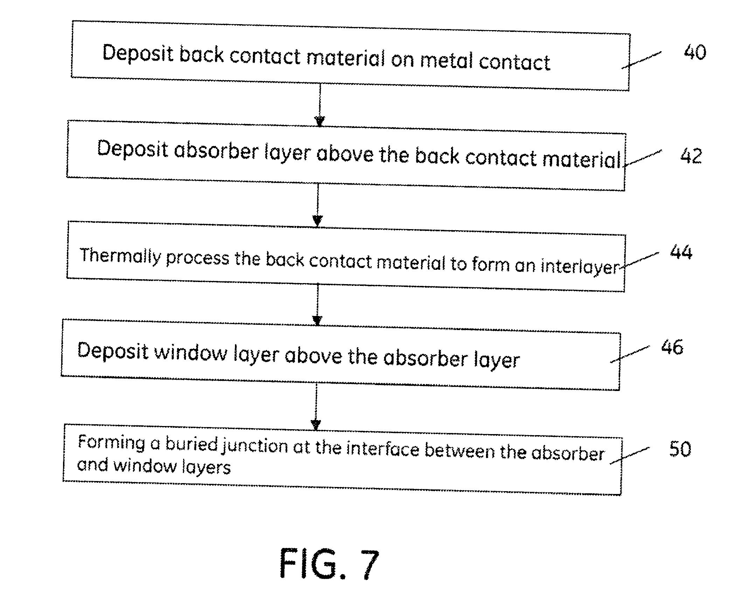

For the example arrangement illustrated in FIGS. 2 and 7, the method further includes, at step 50 forming a buried junction 28 at the interface between the absorber layer 22 and the window layer 24. For particular embodiments, the window layer 24 comprises CdS, and the buried junction 28 is formed by diffusing sulfur from the CdS layer 24 into the absorber layer 22, for example by annealing the semiconductor stack at a temperature in a range of about 400-600 degrees Celsius for about 5-30 minutes. It should be noted that although FIG. 7 shows steps 46 and 50 as being separate, the formation of the buried layer may encompass both the deposition and anneal steps 46, 50. Although not shown in FIG. 7, the method may further include step 48, deposition of the electrically conductive layer 26, as indicated in FIGS. 2 and 6, for example.

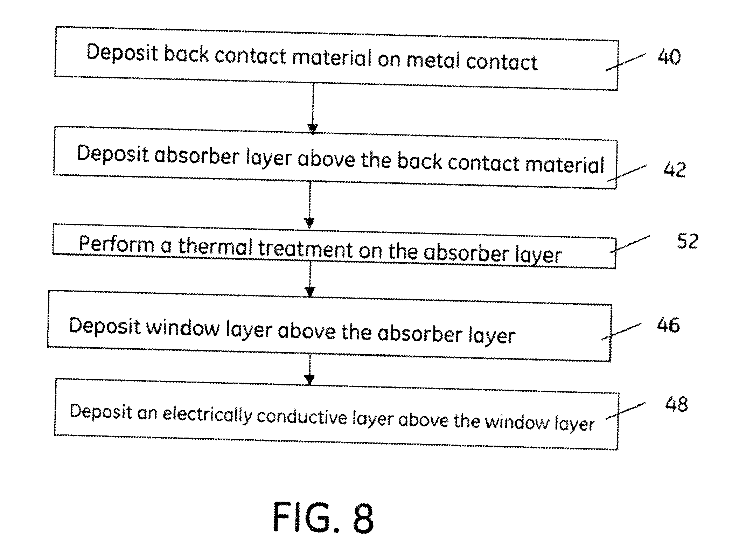

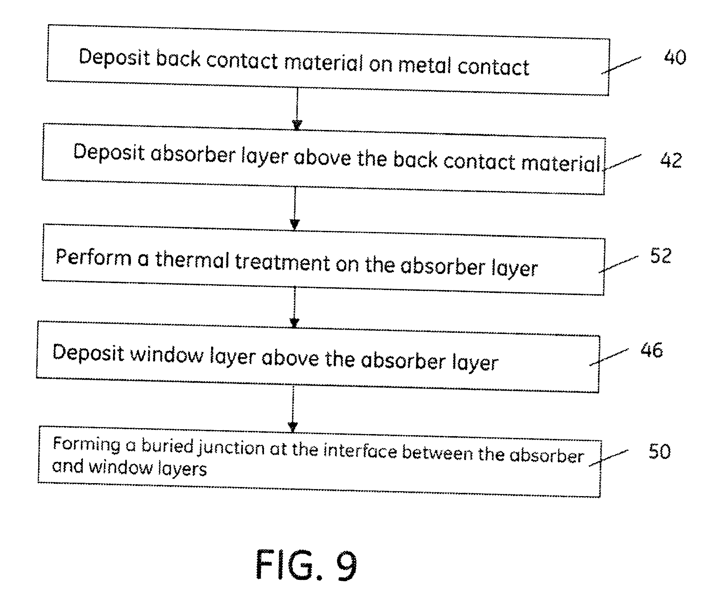

Another method for forming a back contact 12 for a photovoltaic cell 10 is described with reference to FIGS. 1, 8 and 9. Similar to the first method described above with reference to FIGS. 6 and 7, the PV cell 10 is grown in a "substrate" configuration. As indicated in FIG. 1, for example, the PV cell 10 includes at least one semiconductor layer 22, 24. As shown for example in FIGS. 8 and 9, the method includes, at step 40, depositing at least one back contact material 16 on a metal contact 20. For a p-type back contact embodiment, the back contact material comprises magnesium, zinc, copper, mercury, manganese, cesium, arsenic, antimony, bismuth or combinations thereof. In another embodiment, the back contact material comprises indium (for example, In₂S₃ or In₂O₃, etc), aluminum, or gallium, such that an n+-type of back-contact is formed. For this embodiment, the window layer 24 is made p-type, and the absorber layer (CdTe layer) 22 is intrinsic or n-type. For this embodiment, the absorber layer 22 may comprise a material selected from the group consisting of cadmium telluride, cadmium zinc telluride, cadmium sulfur telluride, cadmium manganese telluride, cadmium magnesium telluride and combinations thereof. This group includes lightly doped versions of these materials. According to more particular embodiments, the window layer 24 is p-type and comprises a material selected from the group consisting of zinc telluride, magnesium telluride, amorphous silicon, amorphous silicon carbide; BaCuXF, wherein 'X' comprises sulfur, selenium, or tellurium, LaCuOX, wherein 'X' comprises sulfur, selenium, or tellurium; XCuO(S_{1-y},Se_{y}), wherein 'X' comprises praseodymium, neodymium, or a lanthanide, and wherein y≤1, Sr₂Cu₂ZnO₂S₂, Sr₂CuGaO₃S and combinations or multi-layers thereof.

As shown for example, in FIGS. 8 and 9, the method further includes, at step 42, depositing an absorber layer 22 comprising cadmium (Cd) and tellurium (Te) above the back contact material 16 and, at step 46, depositing a window layer 24 above the absorber layer 22. For the arrangement shown in FIG. 1, the method further includes, at step 48, depositing an electrically conductive layer 26 above the window layer 24. Example materials for the absorber, window and electrically conductive layers 22, 24 and 26 are described above. For example, the absorber layer 22 may comprise a material selected from the group consisting of cadmium telluride, cadmium zinc telluride, cadmium sulfur telluride, cadmium manganese telluride, cadmium magnesium telluride and combinations thereof.

As illustrated in FIGS. 6 and 8, the method further optionally includes, at step 52, performing a thermal treatment on the absorber layer 22 after the deposition of the absorber layer 22, where the deposition and thermal treatment of the absorber layer 22 complete the formation of the back contact 12 for the photovoltaic cell 10. For particular arrangements, the thermal treatment comprises annealing the absorber layer 22. For example, the absorber layer 22 may be annealed at a temperature in a range of about 400-600 degrees Celsius, for a period of about 5-30 minutes. Beneficially, for these embodiments, during the anneal, the interaction between the absorber layer 22 and the back contact material 16 causes the absorber material to interact with the back contact material to form a p+ region 14 to form a low resistance contact, as indicated for example in FIG. 3. However, for other arrangements, the deposition of the absorber layer 22 at step 42 completes the formation of the back contact 12 for the photovoltaic cell 10. For example, the deposition of the absorber layer 22 at relatively high temperatures (for example, 500-600 C) causes the absorber material to interact with the back contact material to form the p+ region 14 to form a low resistance contact, as indicated for example in FIG. 3.

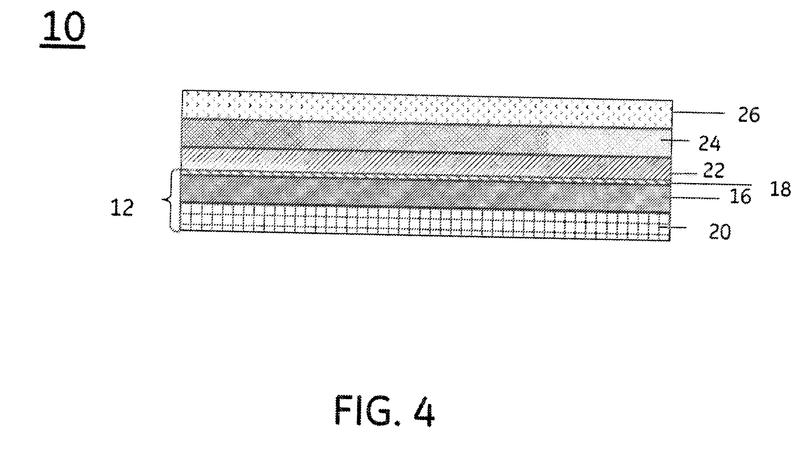

For the example arrangement shown in FIG. 4, the back contact material 16 is selected from the group consisting of magnesium, zinc, copper, mercury, manganese and combinations thereof, such that a telluride 18 forms at the interface between the back contact material 16 and the absorber layer 22 upon reaction of the back contact material 16 with tellurium in the absorber layer 22. For example, cadmium zinc telluride, cadmium manganese telluride, and cadmium magnesium telluride may be formed at the interface between the back contact material 16 and the absorber layer 22, as schematically indicated in FIG. 4, for example. According to a more particular embodiment, the step 42 of depositing the absorber layer 22 comprises forming a tellurium rich CdTe absorber layer 22 above the back contact material 16. For this example process, only a portion of the back contact material 16 (either the metal itself or the impurities) interacts with the tellurium rich CdTe absorber layer 22 to dope the back side of the absorber layer 22.

For other arrangements, the cadmium telluride can be deposited tellurium rich near the interface with the back-contact, such that upon interaction with the back-contact layer, an intermediate layer 18 (see FIG. 4), such as ZnTe, MnTe, MgTe, or CuₓTe, is formed at the back-contact 16 ―absorber layer 22 interface.

For another example arrangement, which is also schematically illustrated by FIG. 4, the back contact material 16 comprises cesium such that such that Cs₂Te, with x≥0, or Cs doped CdₓTe (18), where x≤1, forms at the interface between the back contact material 16 and the absorber layer 22 upon reaction of the cesium with tellurium in the absorber layer 22. For this embodiment, the cesium lowers the work function of the absorber layer 22 to form a low resistance contact.

For particular arrangements, the window layer 24 comprises a material selected from the group consisting of cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂0), amorphous or micro-crystalline silicon and Zn(O,H) and combinations thereof. For the example arrangement depicted in FIGS. 2 and 7, the method further includes, at step 50, forming a buried junction 28 at the interface between the absorber layer 22 and the window layer 24.

For the example arrangement shown in FIG. 4, the step of depositing the absorber layer 22 comprises forming a tellurium rich CdTe absorber layer 22 above the back contact material 16, and the back contact material 16 is selected from the group consisting of arsenic, antimony, bismuth and combinations thereof, such that a telluride 18 forms at the interface between the back contact material 16 and the absorber layer 22 upon reaction of the back contact material 16 with tellurium in the absorber layer 22. For this example process, the back contact material 16 reacts with the tellurium rich CdTe absorber layer 22 to form X₂Te₃, where x is arsenic, antimony or bismuth.

A photovoltaic cell 10 embodiment of the invention, which is grown in a substrate configuration, is described with reference to FIGS. 1 and 2. As shown for example in FIG. 1, the PV cell 10 includes a metal contact 20, and at least one back contact material 16 is disposed on the metal contact 20. The PV cell 10 further includes an absorber layer 22 comprising a material comprising cadmium and tellurium disposed above the back contact material 16, and an interlayer 30 is disposed between the back contact material 16 and the absorber layer 22. The interlayer 30 comprises a compositionally graded layer 30 of the back contact material and the absorber layer material. For example, the interlayer 30 may transition from the back contact material to the absorber layer material over a distance of about 1-50 nm, and more specifically over a distance of 2-20 nm. The PV cell 10 further includes a window layer 24 disposed above the absorber layer 22.

For the arrangement schematically shown in FIG. 1, the PV cell 10 further includes an electrically conductive layer 26 disposed above the window layer 24. For particular arrangements, the electrically conductive layer 26 comprises a transparent conductive oxide (TCO). Example materials and layer thickness are provided above for TCO layer 26.

For particular arrangements, the back contact material 16 comprises a metal nitride or a metal phosphide. Example materials and thicknesses for the metal nitride and metal phosphide arrangements are provided above.

Example materials for the absorber layer 22 and window layer 24 are provided above. For particular arrangements, the absorber layer 22 comprises a material selected from the group consisting of cadmium telluride, cadmium zinc telluride, cadmium sulfur telluride, cadmium manganese telluride, cadmium magnesium telluride and combinations thereof, and the window layer 24 comprises a material selected from the group consisting of cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂O), amorphous or micro-crystalline silicon and Zn(O,H) and combinations thereof.

For the example arrangement depicted in FIG. 2, the photovoltaic cell 10 further includes a buried junction 28 disposed at the interface between the absorber layer 22 and the window layer 24. The buried junction 28 is described above with reference to FIG. 2.

Beneficially, the present invention provides improved back-contacts for CdTe PV devices grown in a "substrate" configuration. By facilitating the growth of CdTe PV cells in a "substrate" configuration, the invention further enables optimization of the properties of the window layer in a CdTe PV device by avoiding the subsequent high-temperature deposition of the absorber layer, which can have a deleterious effect on the properties of the window layer. In this manner, CdTe PV devices with relatively low contact resistances and optimal window layer properties can be achieved.

For completeness, various aspects of the invention are now set out in the following numbered clauses:
1. A method for forming a back contact for a photovoltaic cell that includes at least one semiconductor layer, the method comprising:
   depositing at least one back contact material on a metal contact, wherein the back contact material comprises a metal nitride or a metal phosphide;
   depositing an absorber layer comprising cadmium and tellurium above the back contact material;
   thermally processing the back contact material, such that the back contact material interacts with the absorber layer to form an interlayer that lowers a contact resistance for the photovoltaic cell;
   and
   depositing a window layer above the absorber layer.
2. The method of Clause 1, wherein the thermal processing comprises performing a thermal treatment on the absorber layer after the deposition of the absorber layer, wherein the deposition and thermal treatment of the absorber layer complete the formation of the back contact for the photovoltaic cell.
3. The method of Clause 2, wherein the thermal treatment comprises annealing the absorber layer.
4. The method of Clause 1, wherein the thermal processing is achieved by means of the deposition of the absorber layer, which completes the formation of the back contact for the photovoltaic cell.
5. The method of Clause 1, wherein the absorber layer comprises a material selected from the group consisting of cadmium telluride, cadmium zinc telluride, cadmium sulfur telluride, cadmium manganese telluride, cadmium magnesium telluride and combinations thereof.
6. The method of Clause 1, wherein the back contact material comprises a metal nitride.
7. The method of Clause 1, wherein the back contact material comprises a metal phosphide.
8. The method of Clause 1, wherein the window layer comprises a material selected from the group consisting of cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂O) amorphous or micro-crystalline silicon and Zn(O,H) and combinations thereof.
9. The method of Clause 8, further comprising forming a buried junction at the interface between the absorber layer and the window layer.
10. A method for forming a back contact for a photovoltaic cell that includes at least one semiconductor layer, the method comprising:
   depositing at least one back contact material on a metal contact, wherein the back contact material comprises magnesium, zinc, copper, mercury, manganese, cesium, arsenic, antimony,
   bismuth or combinations thereof;
   depositing an absorber layer comprising cadmium (Cd) and tellurium (Te) above the back contact material; and
   depositing a window layer above the absorber layer.
11. The method of Clause 10, further comprising performing a thermal treatment on the absorber layer after the deposition of the absorber layer, wherein the deposition and thermal treatment of the absorber layer complete the formation of the back contact for the photovoltaic cell.
12. The method of Clause 11, wherein the thermal treatment comprises annealing the absorber layer.
13. The method of Clause 10, wherein the deposition of the absorber layer completes the formation of the back contact for the photovoltaic cell.
14. The method of Clause 10, wherein the absorber layer comprises a material selected from the group consisting of cadmium telluride, cadmium zinc telluride, cadmium sulfur telluride, cadmium manganese telluride, cadmium magnesium telluride and combinations thereof.
15. The method of Clause 10, wherein the back contact material is selected from the group consisting of magnesium, zinc, copper, mercury, bismuth, manganese and combinations thereof, such that a telluride forms at an interface between the back contact material and the absorber layer upon reaction of the back contact material with tellurium in the absorber layer.
16. The method of Clause 15, wherein the step of depositing the absorber layer comprises forming a tellurium rich CdTe absorber layer above the back contact material.
17. The method of Clause 10, wherein the back contact material comprises cesium such that such that Cs₂₋ₓTe, with x≥0, or Cs-doped CdₓTe, where x≤1, forms at an interface between the back contact material and the absorber layer upon reaction of the cesium with tellurium in the absorber layer.
18. The method of Clause 10, wherein the window layer comprises a material selected from the group consisting of cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂O), amorphous or micro-crystalline silicon and Zn(O,H) and combinations thereof.
19. The method of Clause 18, further comprising forming a buried junction at the interface between the absorber layer and the window layer.
20. The method of Clause 10, wherein the step of depositing the absorber layer comprises forming a tellurium rich CdTe absorber layer above the back contact material, wherein the back contact material is selected from the group consisting of arsenic, antimony, bismuth and combinations thereof, such that a telluride forms at an interface between the back contact material and the absorber layer upon reaction of the back contact material with tellurium in the absorber layer.
21. A photovoltaic cell comprising:
   a metal contact;
   at least one back contact material disposed on the metal contact;
   an absorber layer comprising a material comprising cadmium and tellurium disposed above the back contact material;
   an interlayer disposed between the back contact material and the absorber layer and comprising a compositionally graded layer of the back contact material and the absorber layer material; and
   a window layer disposed above the absorber layer.
22. The photovoltaic cell of Clause 21, wherein the back contact material comprises a metal nitride or a metal phosphide.
23. The photovoltaic cell of Clause 21, wherein the absorber layer comprises a material selected from the group consisting of cadmium telluride, cadmium zinc telluride, cadmium sulfur telluride, cadmium manganese telluride, cadmium magnesium telluride and combinations thereof, and wherein the window layer (24) comprises a material selected from the group consisting of cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂O), amorphous or micro-crystalline silicon and Zn(O,H) and combinations thereof.
24. The photovoltaic cell of Clause 23, further comprising further a buried junction disposed at the interface between the absorber layer and the window layer.
25. A method for forming a back contact for a photovoltaic cell that includes at least one semiconductor layer, the method comprising:
   depositing at least one back contact material on a metal contact, wherein the back contact material comprises indium, gallium, aluminum or combinations thereof;
   depositing an absorber layer comprising cadmium (Cd) and tellurium (Te) above the back contact material; and
   depositing a window layer above the absorber layer.
26. The method of Clause 25, further comprising performing a thermal treatment on the absorber layer after the deposition of the absorber layer, wherein the deposition and thermal treatment of the absorber layer complete the formation of the back contact for the photovoltaic cell.
27. The method of Clause 26, wherein the thermal treatment comprises annealing the absorber layer.
28. The method of Clause 25, wherein the deposition of the absorber layer completes the formation of the back contact for the photovoltaic cell.
29. The method of Clause 25, wherein the absorber layer comprises a material selected from the group consisting of cadmium telluride, cadmium zinc telluride, cadmium sulfur telluride, cadmium manganese telluride, cadmium magnesium telluride and combinations thereof.
30. The method of Clause 25, wherein the window layer comprises a material selected from the group consisting of zinc telluride, magnesium telluride, amorphous silicon, amorphous silicon carbide; BaCuXF, wherein 'X' comprises sulfur, selenium, or tellurium, LaCuOX, wherein 'X' comprises sulfur, selenium, or tellurium; XCuO(S_{1-y},Se_{y}), wherein 'X' comprises praseodymium, neodymium, or a lanthanide, and wherein y≤1, Sr₂Cu₂ZnO₂S₂, Sr₂CuGaO₃S and combinations or multi-layers thereof.
31. The method of Clause 30, further comprising forming a buried junction at the interface between the absorber layer and the window layer.

## Claims

1. A method for forming a back contact (12) for a photovoltaic cell (10) that includes at least one semiconductor layer (22, 24), the method comprising:
depositing at least one back contact material (16) on a metal contact (20), wherein the back contact material comprises a metal nitride or a metal phosphide;
depositing an absorber layer (22) comprising cadmium and tellurium above the back contact material (16);
thermally processing the back contact material (16), such that the back contact material interacts with the absorber layer (22) to form an interlayer (30) that lowers a contact resistance for the photovoltaic cell (10); and
depositing a window layer (24) above the absorber layer (22).

2. The method of Claim 1, wherein the thermal processing comprises performing a thermal treatment on the absorber layer (22) after the deposition of the absorber layer (22), wherein the deposition and thermal treatment of the absorber layer (22) complete the formation of the back contact (12) for the photovoltaic cell (10).

3. The method of Claim 1, wherein the thermal processing is achieved by means of the deposition of the absorber layer (22), which completes the formation of the back contact (12) for the photovoltaic cell (10).

4. The method of any preceding claim, wherein the absorber layer (22) comprises a material selected from the group consisting of cadmium telluride, cadmium zinc telluride, cadmium sulfur telluride, cadmium manganese telluride, cadmium magnesium telluride and combinations thereof, and wherein the window layer (24) comprises a material selected from the group consisting of cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂O), amorphous or micro-crystalline silicon and Zn(O,H) and combinations thereof.

5. The method of any preceding claim further comprising forming a buried junction (28) at the interface between the absorber layer (22) and the window layer (24).

6. A method for forming a back contact (12) for a photovoltaic cell (10) that includes at least one semiconductor layer (22, 24), the method comprising:
depositing at least one back contact material (16) on a metal contact (20), wherein the back contact material comprises magnesium, zinc, copper, mercury, manganese, cesium, arsenic, antimony, bismuth or combinations thereof;
depositing an absorber layer (22) comprising cadmium (Cd) and tellurium (Te) above the back contact material (16); and
depositing a window layer (24) above the absorber layer (22).

7. The method of Claim 6, wherein the back contact material (16) is selected from the group consisting of magnesium, zinc, copper, mercury, bismuth, manganese and combinations thereof, such that a telluride (18) forms at an interface between the back contact material (16) and the absorber layer (22) upon reaction of the back contact material with tellurium in the absorber layer, wherein the step of depositing the absorber layer (22) comprises forming a tellurium rich CdTe absorber layer (22) above the back contact material (16).

8. The method of Claim 6, wherein the back contact material (16) comprises cesium such that such that Cs₂₋ₓTe, with x≥O, or Cs-doped CdₓTe (18), where x≤1, forms at an interface between the back contact material (16) and the absorber layer (22) upon reaction of the cesium with tellurium in the absorber layer.

9. The method of Claim 6, wherein the step of depositing the absorber layer (22) comprises forming a tellurium rich CdTe absorber layer (22) above the back contact material (16), wherein the back contact material (16) is selected from the group consisting of arsenic, antimony, bismuth and combinations thereof, such that a telluride (18) forms at an interface between the back contact material (16) and the absorber layer (22) upon reaction of the back contact material with tellurium in the absorber layer.

10. A photovoltaic cell (10) comprising:
a metal contact (20);
at least one back contact material (16) disposed on the metal contact (20);
an absorber layer (22) comprising a material comprising cadmium and tellurium disposed above the back contact material (16);
an interlayer (30) disposed between the back contact material (16) and the absorber layer (22) and comprising a compositionally graded layer (30) of the back contact material and the absorber layer material; and
a window layer (24) disposed above the absorber layer (22).

11. A method for forming a back contact (12) for a photovoltaic cell (10) that includes at least one semiconductor layer (22, 24), the method comprising:
depositing at least one back contact material (16) on a metal contact (20), wherein the back contact material comprises indium, gallium, aluminum or combinations thereof;
depositing an absorber layer (22) comprising cadmium (Cd) and tellurium (Te) above the back contact material (16); and
depositing a window layer (24) above the absorber layer (22).

12. The method of Claim 11, wherein the absorber layer (22) comprises a material selected from the group consisting of cadmium telluride, cadmium zinc telluride, cadmium sulfur telluride, cadmium manganese telluride, cadmium magnesium telluride and combinations thereof, and wherein the window layer (24) comprises a material selected from the group consisting of zinc telluride, magnesium telluride, amorphous silicon, amorphous silicon carbide; BaCuXF, wherein 'X' comprises sulfur, selenium, or tellurium, LaCuOX, wherein 'X' comprises sulfur, selenium, or tellurium; XCuO(S_{1-y},Se_{y}), wherein 'X' comprises praseodymium, neodymium, or a lanthanide, and wherein y≤1, Sr₂Cu₂ZnO₂S₂, Sr₂CuGaO₃S and combinations or multi-layers thereof.

13. The method of Claim 11 or Claim 12, further comprising forming a buried junction (28) at the interface between the absorber layer (22) and the window layer (24).
